(19) **Europäisches Patentamt**
**European Patent Office**
**Office européen des brevets**

(11) **EP 2 352 180 A1**

(12) **EUROPEAN PATENT APPLICATION**
published in accordance with Art. 153(4) EPC

(43) Date of publication:
**03.08.2011 Bulletin 2011/31**

(51) Int Cl.:
*H01L 31/075* (2006.01)   *H01L 31/0368* (2006.01)
*H01L 31/20* (2006.01)

(21) Application number: **10790339.5**

(22) Date of filing: **25.02.2010**

(86) International application number:
**PCT/JP2010/052973**

(87) International publication number:
**WO 2011/007593 (20.01.2011 Gazette 2011/03)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **13.07.2009 JP 2009165017**

(71) Applicant: **Sanyo Electric Co., Ltd.**
**Osaka 570-8677 (JP)**

(72) Inventors:
• **MURATA, Kazuya**
**Moriguchi-shi**
**Osaka 570-8677 (JP)**

• **KATAYAMA, Hirotaka**
**Moriguchi-shi**
**Osaka 570-8677 (JP)**
• **MATSUMOTO, Mitsuhiro**
**Moriguchi-shi**
**Osaka 570-8677 (JP)**
• **AYA, Yoichiro**
**Moriguchi-shi**
**Osaka 570-8677 (JP)**

(74) Representative: **Cross, Rupert Edward Blount et al**
**Boult Wade Tennant**
**Verulam Gardens**
**70 Gray's Inn Road**
**London WC1X 8BT (GB)**

(54) **THIN FILM SOLAR CELL AND METHOD FOR MANUFACTURING SAME**

(57)    A thin film solar cell is employed having a power generation layer formed with a microcrystalline silicon film including, in its plane, a first region and a second region in which a percentage of crystallization is lower than the first region and a carrier lifetime is higher than the first region.

FIG. 5

EP 2 352 180 A1

## Description

TECHNICAL FIELD

The present invention relates to a thin film solar cell and a manufacturing method thereof.

BACKGROUND ART

A thin film solar cell is formed by sequentially layering a first electrode, one or more semiconductor thin film photoelectric conversion units, and a second electrode over a substrate having an insulating surface. Each photoelectric conversion unit is formed by layering a p-type layer, an i-type layer which forms a power generation layer, and an n-type layer from a side of incidence of light.

As such a thin film solar cell, JP Hei 11-274530 A discloses a thin film solar cell having a microcrystalline silicon film as a power generation layer. For example, a single thin film solar cell is known having a single unit of the microcrystalline silicon photoelectric conversion unit.

SUMMARY OF THE INVENTION

Technical Problems

Normally, in order to improve a power generation characteristic in a thin film solar cell, it is preferable that the crystallinity in a plane of the microcrystalline silicon film be as uniform as possible. However, in reality, due to the capability of the film formation device for the microcrystalline silicon film or a further increase in the area of the solar cell panel, it is difficult to achieve uniform crystallinity in the plane of the microcrystalline silicon film, and thus there are cases where the characteristic of the overall solar cell panel is reduced.

Solution to Problems

According to one aspect of the present invention, there is provided a thin film solar cell having a microcrystalline silicon film as a power generation layer, wherein the microcrystalline silicon film of the power generation layer includes, in its plane, a first region and a second region in which a percentage of crystallization is lower than the first region and a carrier lifetime is higher than the first region.

According to another aspect of the present invention, there is provided a method of manufacturing a thin film solar cell having a microcrystalline silicon film as a power generation layer, comprising the step of forming the microcrystalline silicon film including, in its plane, a first region and a second region in which a percentage of crystallization is lower than the first region and a carrier lifetime is higher than the first region.

Advantageous Effects of Invention

According to various aspects of the present invention, the power generation characteristic in the thin film solar cell can be improved.

BRIEF DESCRIPTION OF THE DRAWINGS

FIG. 1 is a diagram showing a structure of a tandem-type thin film solar cell according to a preferred embodiment of the present invention.
FIG. 2 is a diagram showing a structure of a $\mu$c-Si unit of a tandem-type thin film solar cell according to a preferred embodiment of the present invention.
FIG. 3 is a diagram for explaining a method of manufacturing an i-type layer of a $\mu$c-Si unit in a preferred embodiment of the present invention.
FIG. 4 is a diagram showing an example structural distribution in a plane of an i-type layer of a $\mu$c-Si unit according to a preferred embodiment of the present invention.
FIG. 5 is a diagram showing an example structural distribution in a plane of an i-type layer of a $\mu$c-Si unit according to a preferred embodiment of the present invention.
FIG. 6 is a diagram showing an in-plane distribution of a carrier lifetime in an i-type layer of a $\mu$c-Si unit according to a preferred embodiment of the present invention.

FIG. 7 is a diagram showing an in-plane distribution of a percentage of crystallization of an i-type layer of a $\mu$c-Si unit according to a preferred embodiment of the present invention.

FIG. 8 is a diagram showing an in-plane distribution of a power generation efficiency of a tandem-type thin film solar cell in a preferred embodiment of the present invention.

BEST MODE FOR CARRYING OUT THE INVENTION

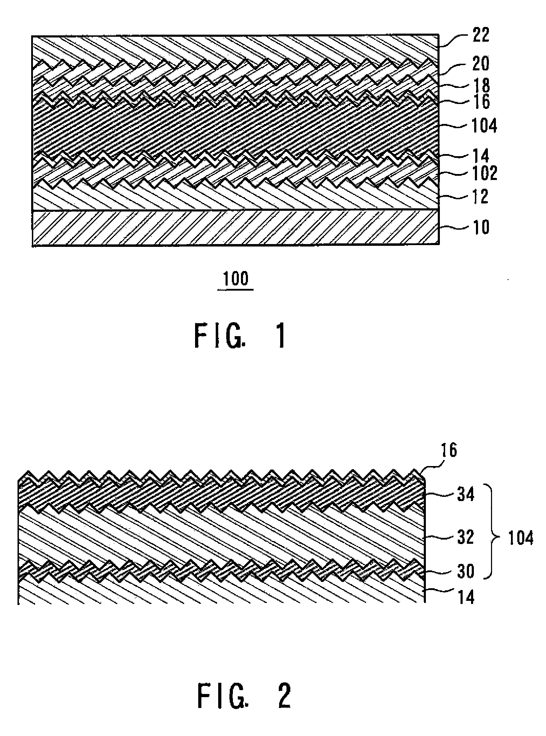

FIG. 1 is a cross sectional view showing a structure of a tandem-type thin film solar cell 100 according to a preferred embodiment of the present invention. The tandem-type thin film solar cell 100 in the present embodiment has a structure in which a transparent insulating substrate 10 is set as a side of incidence of light, and a transparent conductive film 12, an amorphous silicon photoelectric conversion unit (a-Si unit) 102 functioning as a top cell and having a wide band gap, an intermediate layer 14, a microcrystalline silicon photoelectric conversion unit ($\mu$c-Si unit) 104 functioning as a bottom cell and having a narrower band gap than the a-Si unit 102, a first backside electrode layer 16, a second backside electrode layer 18, a filler 20, and a back sheet 22 are layered from the side of incidence of light.

A structure and a manufacturing method of the tandem-type thin film solar cell 100 in the preferred embodiment of the present invention will now be described. The tandem-type thin film solar cell 100 in the preferred embodiment of the present invention is characterized by having the i-type layer included in the $\mu$c-Si unit 104, and thus the i-type layer included in the $\mu$c-Si unit 104 will be particularly described in detail.

For the transparent insulating substrate 10, for example, a material which transmits light at least in a visible light wavelength region may be used, such as, for example, a glass substrate and a plastic substrate. The transparent conductive film 12 is formed over the transparent insulating substrate 10. For the transparent conductive film 12, it is preferable to use at least one or a combination of a plurality of transparent conductive oxides (TCO) in which tin (Sn), antimony (Sb), fluorine (F), aluminum (Al), or the like is included in tin oxide ($SnO_2$), zinc oxide (ZnO), indium tin oxide (ITO), or the like. In particular, zinc oxide (ZnO) is preferred because it has a high light transmittance, a low resistivity, and a high plasma-resisting characteristic. The transparent conductive film 12 may be formed, for example, through sputtering. A thickness of the transparent conductive film 12 is preferably in a range of greater than or equal to 500 nm, and less than or equal to 5000 nm. In addition, unevenness having a light confinement effect is preferably formed over the surface of the transparent conductive film 12.

When a structure is employed for the tandem-type thin film solar cell 100 in which a plurality of cells are connected in series, the transparent conductive film 12 is patterned in a strip shape. For example, the transparent conductive film 12 can be patterned in the strip shape using a YAG laser having a wavelength of 1064 nm, an energy density of 13 J/cm$^3$, and a pulse frequency of 3 kHz.

Silicon-based thin films including a p-type layer, an i-type layer, and an n-type layer are sequentially layered over the transparent conductive film 12 to form the a-Si unit 102. The a-Si unit 102 can be formed through plasma chemical vapor deposition (plasma CVD) in which mixture gas, in which silicon-containing gas such as silane ($SiH_4$), disilane ($Si_2H_6$), and dichlorsilane ($SiH_2Cl_2$), carbon-containing gas such as methane ($CH_4$), p-type dopant-containing gas such as diborane ($B_2H_6$), n-type dopant-containing gas such as phosphine ($PH_3$), and dilution gas such as hydrogen ($H_2$) are mixed, is made into plasma and a film is formed.

For the plasma CVD, for example, an RF plasma CVD of 13.56 MHz is preferably applied. The RF plasma CVD may be of a parallel-plate type. Alternatively, a structure may be employed in which a gas shower hole for supplying mixture gas of the materials is formed on a side, of the parallel-plate type electrodes, on which the transparent insulating substrate 10 is not placed. An input power density of the plasma is preferably greater than or equal to 5 mW/cm$^2$ and less than or equal to 300 mW/cm$^2$.

The p-type layer has a single layer, or layered structure of an amorphous silicon layer, a microcrystalline silicon thin film, a microcrystalline silicon carbide thin film, or the like, doped with a p-type dopant (such as boron) and having a thickness of greater than or equal to 5 nm, and less than or equal to 50 nm. The film characteristic of the p-type layer may be changed by adjusting the mixture ratios of the silicon-containing gas, the p-type dopant-containing gas, and the dilution gas, pressure, and plasma generating high-frequency power. The i-type layer is an amorphous silicon film formed over the p-type layer, not doped with any dopant, and having a thickness of greater than or equal to 50 nm and less than or equal to 500 nm. The film characteristic of the i-type layer may be changed by adjusting the mixture ratios of the silicon-containing gas and the dilution gas, pressure, and plasma generating high-frequency power. The i-type layer becomes the power generation layer of the a-Si unit 102. The n-type layer is an n-type microcrystalline silicon layer (n-type $\mu$c-Si:H) formed over the i-type layer, doped with an n-type dopant (such as phosphorus), and having a thickness of greater than or equal to 10 nm and less than or equal to 100 nm. The film characteristic of the n-type layer may be changed by adjusting the mixture ratios of the silicon-containing gas, the carbon-containing gas, the n-type dopant-containing gas, and the dilution gas, pressure, and plasma generating high-frequency power.

The intermediate layer 14 is formed over the a-Si unit 102. For the intermediate layer 14, a transparent conductive oxide (TCO) such as zinc oxide (ZnO), silicon oxide (SiOx), or the like is preferably used. In particular, zinc oxide (ZnO) or silicon oxide (SiOx) to which magnesium (Mg) is introduced is preferably used. The intermediate layer 14 is formed, for example, through sputtering or the like. A thickness of the intermediate layer 14 is preferably in a range of greater than or equal to 10 nm and less than or equal to 200 nm. Alternatively, the intermediate layer 14 may be omitted.

FIG. 2 is a diagram enlarging a cross sectional structure of the $\mu$c-Si unit 104. Over the intermediate layer 14, the $\mu$c-Si unit 104 is formed in which a p-type layer 30, an i-type layer 32, and an n-type layer 34 are sequentially layered. The $\mu$c-Si unit 104 can be formed through plasma CVD in which mixture gas, in which silicon-containing gas such as silane ($SiH_4$), disilane ($Si_2H_6$), and dichlorsilane ($SiH_2Cl_2$), carbon-containing gas such as methane ($CH_4$), p-type dopant-containing gas such as diborane ($B_2H_6$), n-type dopant-containing gas such as phosphine ($PH_3$), and dilution gas such as hydrogen ($H_2$) are mixed, is made into plasma and a film is formed.

Similar to the a-Si unit 102, as the plasma CVD, for example, an RF plasma CVD of 13.56 MHz is preferably applied. The RF plasma CVD may be of a parallel-plate type. Alternatively, a structure may be employed in which a gas shower hole for supplying mixture gas of materials is formed on a side, of the parallel-plate type electrodes, on which the transparent insulating substrate 10 is not placed. An input power density of plasma is preferably greater than or equal to 5 mW/cm$^2$ and less than or equal to 2000 mW/cm$^2$.

The p-type layer 30 is a microcrystalline silicon layer ($\mu$c-Si:H) having a thickness of greater than or equal to 5 nm and less than or equal to 50 nm, and doped with a p-type dopant (such as boron). The film characteristic of the p-type layer may be changed by adjusting the mixture ratios of the silicon-containing gas, the p-type dopant-containing gas, and the dilution gas, pressure, and plasma generating high-frequency power.

The i-type layer 32 is a microcrystalline silicon layer ($\mu$c-Si:H) formed over the p-type layer 30, having a thickness of greater than or equal to 500 nm and less than or equal to 5000 nm, and not doped with any dopant. The film characteristic of the i-type layer 32 may be changed by adjusting the mixture ratios of the silicon-containing gas and the dilution gas, pressure, and plasma-generating high-frequency power.

The i-type layer 32 includes, in a plane of a light incidence surface of the tandem-type thin film solar cell 100, a first region and a second region having crystallinities and carrier lifetimes which differ from each other. Specifically, the i-type layer 32 has a structure in which, in a plane of the light incidence surface of the tandem-type thin film solar cell 100, a first region having a high crystallinity and a low carrier lifetime and a second region having a relatively low crystallinity compared to the first region and a relatively high carrier lifetime are distributed.

When the carrier lifetime in the first region is considered as 1, the carrier lifetime of the second region is preferably greater than or equal to 1.05. The carrier lifetime is measured through Microwave Photo Conductivity Decay method ($\mu$-PCD method) after a microcrystalline silicon film is formed over a glass substrate to a thickness of 600 nm under the same film formation conditions as the conditions when the i-type layer 32 of the tandem-type thin filmsolar cell 100 is formed. More specifically, amethoddescribed in "Detection of Heavy Metal Contamination in Semiconductor Processes Using a Carrier Lifetime Measurement System", KOBE STEEL ENGINEERING REPORTS, Vol. 52, No. 2, September, 2002, pp. 87 - 93, is applied. Inthe $\mu$-PCD method, light is instantaneously irradiated on each region in a plane of the microcrystalline silicon film formed over the glass substrate, and attenuation by re-combination of the carriers generated in the film due to the light is measured as a change of a reflection intensity of a microwave separately irradiated to the microcrystalline silicon film.

When the crystallinity of the second region is considered as 1, the crystallinity of the first region is preferably greater than or equal to 1.1. The crystallinity is measured using Raman spectroscopy after a microcrystalline silicon film is formed over a glass substrate to a thickness of 600 nmunder the same film formation conditions as the conditions for forming the i-type layer 32 of the tandem-type thin film solar cell 100. More specifically, light is irradiated to each region in the plane of the microcrystalline silicon film formed over the glass substrate, and based on a peak intensity $I_{520}$ around 520 cm$^{-1}$ derived from the crystalline silicon in the spectrum of the Raman scattering and a peak intensity $I_{480}$ around 480 cm$^{-1}$ derived from amorphous silicon, Equation (1) is applied, and a percentage of crystallization X (%) is calculated.

```
(Equation (1))
```

$$\text{Percentage of Crystallization X (\%)} = I_{520}/(I_{520} + I_{480}) \qquad (1)$$

The i-type layer 32 is formed in a film formation chamber having a substrate heater, a substrate carrier, and a plasma electrode built in the chamber. The film formation chamber is vacuumed by a vacuum pump. The substrate heater is placed such that a heating surface opposes the plasma electrode. The transparent insulating substrate 10 placed on the substrate carrier is transported between the plasma electrode and the substrate heater in a manner to oppose the plasma electrode. The plasma electrode is electrically connected to a plasma power supply through a matching box provided outside of the film formation chamber.

In such a structure, while the material gas is supplied at a flow rate and a pressure according to the film formation conditions, power is input from the plasma power supply to the plasma electrode, to generate plasma of the material gas in a gap between the plasma electrode and the transparent insulating substrate 10 and form a film over the surface of the transparent insulating substrate 10.

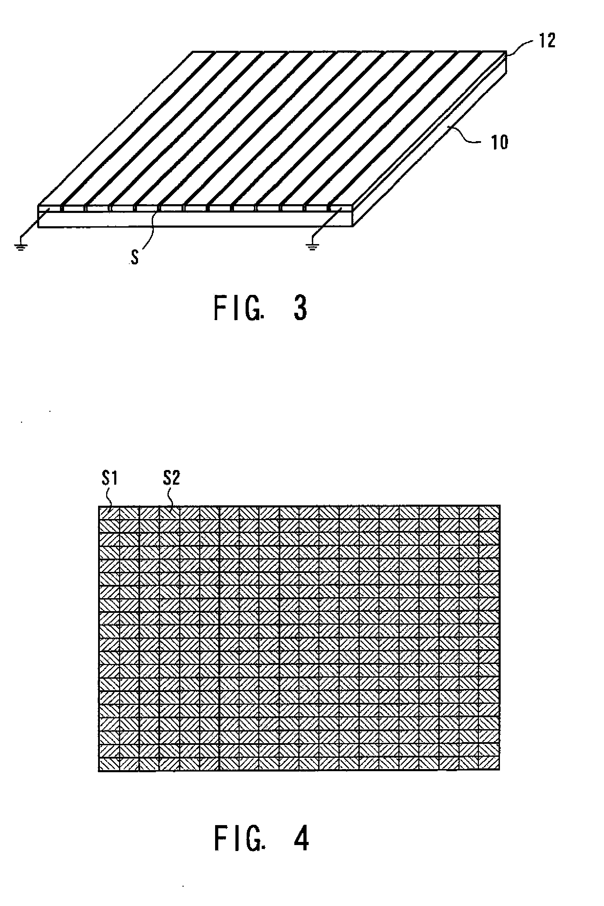

The i-type layer 32 can be formed by employing different states of plasma of the reaction gas between the first region and the second region during the film formation. As a first method, as shown in FIG. 3, the film is formed in a state where the different potentials are set for the regions of the transparent conductive film 12 patterned in the strip shape with the slit S. For example, the transparent conductive film 12 corresponding to the first region may be set to a floating state and the transparent conductive film 12 corresponding to the second region may be grounded, and the plasma CVD may be applied, to obtain the in-plane distribution of the i-type layer 32. In FIG. 3, in order to clarify the description, the a-Si unit 102, the intermediate layer 14, the p-type layer 30 of the $\mu$c-Si unit 104, etc. formed over the transparent conductive film 12 are not shown.

As a second method, the shape of the plasma electrode may be set to different shapes for the first region and the second region, to adjust the state of the generated plasma of the material gas in the plane corresponding to the first region and the second region. As a third method, a shape, a size, a number, etc. of the gas shower holes formed in the plasma electrode may be set to different configurations corresponding to the first region and the second region, to adjust the state of the generated plasma of the material gas in the plane.

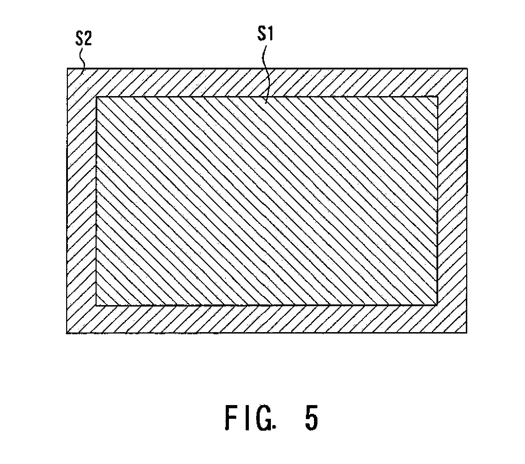

FIGs. 4 and 5 show an example in-plane structure of the i-type layer 32 at the surface of incidence of the light of the tandem-type thin film solar cell 100. FIGs. 4 and 5 show a first region S1 and a second region S2 with hatchings slanted at different angles. In the example configuration of FIG. 4, the first region S1 and the second region S2 are alternately placed in a lattice form. In the example configuration of FIG. 5, the first region S1 is placed at a center portion in the plane and the second region S2 is placed around the first region S1.

The n-type layer 34 is formed by layering a microcrystalline silicon layer (n-type $\mu$c-Si:H) having a thickness of greater than or equal to 5 nm and less than or equal to 50 nm and doped with an n-type dopant (such as phosphorus). The film characteristic of the n-type layer 34 may be changed by adjusting the mixture ratios of the silicon-containing gas, the carbon-containing gas, the n-type dopant-containing gas, and the dilution gas, pressure, and plasma generating high-frequency power.

When a plurality of cells are connected in series, the a-Si unit 102 and the $\mu$c-Si unit 104 are patterned into a strip shape. A YAG laser is irradiated at a position aside from the patterning position of the transparent conductive film 12 by 50 $\mu$m, to form a slit, and to pattern the a-Si unit 102 and the $\mu$c-Si unit 104 in the strip shape. As the YAG laser, for example, a YAG laser having an energy density of 0.7 J/cm$^3$, and a pulse frequency of 3 kHz is preferably used.

Over the $\mu$c-Si unit 104, a layered structure of a transparent conductive oxide (TCO) and a reflective metal is formed as the first backside electrode layer 16 and the second backside electrode layer 18. As the first backside electrode layer 16, a transparent conductive oxide (TCO) such as tin oxide ($SnO_2$), zinc oxide (ZnO), and indium tin oxide (ITO) is used. As the second backside electrode layer 18, a metal such as silver (Ag) and aluminum (Al) is used. The TCO may be formed, for example, through sputtering. The first backside electrode layer 16 and the second backside electrode layer 18 are preferably formed to a total thickness of approximately 1000 nm. Unevenness for improving the light confinement effect is preferably provided on at least one of the first backside electrode layer 16 and the second backside electrode layer 18.

When a plurality of cells are connected in series, the first backside electrode layer 16 and the second backside electrode layer 18 are patterned in a strip shape. A YAG laser is irradiated at a position aside from the patterning position of the a-Si unit 102 and the $\mu$c-Si unit 104 by 50 $\mu$m, to form a slit C, and pattern the first backside electrode layer 16 and the second backside electrode layer 18 in a strip shape. As the YAG laser, a YAG laser having an energy density of 0.7 J/cm$^3$ and a pulse frequency of 4 kHz is preferably used.

In addition, a surface of the second backside electrode layer 18 is covered by a back sheet 22 with a filler 20. The filler 20 and the back sheet 22 may be made of resin materials such as EVA, polyimide, or the like. With this configuration, it is possible to prevent intrusion of moisture or the like into the power generation layer of the tandem-type thin film solar cell 100.

The tandem-type thin film solar cell 100 is configured in the above-described manner. In the present embodiment, in a plane of the tandem-type thin film solar cell 100, a first region in which the percentage of crystallization is high and the carrier lifetime is short, and a second region in which the percentage of crystallization is lower than the first region and the carrier lifetime is higher are provided in the i-type layer 32 of the $\mu$c-Si unit 104.

With this configuration, with the film formation conditions at the substrate periphery or the like, for example, it is possible to have a high carrier lifetime in a region of the i-type layer 32 where the crystallinity is low, and have a low carrier lifetime in a region where the crystallinity is higher than the above-described region, and thus uniform power generation efficiency can be achieved in the plane of the tandem-type thin film solar cell 100. This is advantageous when the tandem-type thin film solar cell 100 is made into a module.

When the tandem-type thin film solar cell 100 is made into a panel, even if moisture enters from the outside at the peripheral portion of the substrate, by setting the crystallinity of the i-type layer 32 at the peripheral portion to a low value, it is possible to reduce the tendency of detachment compared to the related art.

<Example>

An Example of the present invention will now be described. In the following, an example will be described in which a glass substrate of 45 cm x 50 cm size and 4 mm thickness was used as the transparent insulating substrate 10, and zinc oxide (ZnO) having 1000 nm thickness and formed by forming a transparent electrode film through sputtering over the transparent insulating substrate 10 and etching the surface with hydrochloric acid of 0.5%, to form unevenness, was used as the transparent conductive film 12. The transparent conductive film 12 was patterned into a strip shape by a YAG laser having a wavelength of 1064 nm, an energy density of 13 $J/cm^3$, and a pulse frequency of 3 kHz.

In a manufacturing device 200, a shower plate type plasma electrode 48 was employed in which the material gas can be supplied in a shower-like manner from the surface of the electrode.

Over the transparent insulating substrate 10, the p-type layer, the i-type layer, and the n-type layer of the a-Si unit 102 were sequentially formed. Table 1 shows film formation conditions of the a-Si unit 102. Then, after zinc oxide (ZnO) was formed as the intermediate layer 14, the p-type layer 30, the i-type layer 32, and the n-type layer 34 of the $\mu$c-Si unit 104 were sequentially formed. Table 1 shows film formation conditions of the a-Si unit 104. In Table 1, for diborane ($B_2H_6$) and phosphine ($PH_3$), gas of a concentration of 1% based on hydrogen was used.

In this process, in the transparent conductive film 12 patterned over the transparent insulating substrate 10, the transparent conductive film 12 at the peripheral portion of the transparent insulating substrate 10 was grounded and the transparent conductive film 12 at the center portion of the transparent insulating substrate 10 was set floating, to form the i-type layer 32 of the $\mu$c-Si unit 104. With this process, in the plane of the tandem-type thin film solar cell 100, the first region in which the percentage of crystallization is high and the carrier lifetime is low was formed at the center potion, and a second region in which the percentage of crystallization is lower than the first region and the carrier lifetime is higher than the first region was formed at the peripheral portion.

In the formation of the i-type layer 32 of the $\mu$c-Si unit 104, when the i-type layer 32 was formed with a pressure of the material gas of less than or equal to 300 Pa, both the crystallinity and carrier lifetime were reduced. On the other hand, when the pressure of the material gas was greater than or equal to 600 Pa during the film formation of the i-type layer 32 of the $\mu$c-Si unit 104, even when the crystallinity was reduced, the carrier lifetime was increased.

[Table 1]

| | Layer | Substrate Temperature (°C) | Gas Flow Rate (sccm) | Reaction Pressure (Pa) | RF Power (W) | Film Thickness (nm) |
|---|---|---|---|---|---|---|
| a-$S_i$ UNIT 102 | p-Type Layer | 180 | $S_iH_4$ : 100<br>$CH_4$ : 100<br>$H_2$ : 1000<br>$B_2H_6$ : 50 | 100 | 30 ($11mW/cm^2$) | 10 |
| | i-Type Layer | 180 | $SiH_4$ : 300<br>$H_2$ : 2000 | 100 | 30 ($11mW/cm^2$) | 300 |
| | n-Type Layer | 180 | $S_iH_4$ : 10<br>H2 : 2000<br>$PH_3$ : 5 | 200 | 300 ($110mW/cm^2$) | 20 |
| $\mu$C-$S_i$ UNIT | p-Type Layer | 180 | $S_iH_4$ : 10<br>$H_2$ : 2000<br>$B_2H_6$ : 5 | 200 | 300 ($110mW/cm^2$) | 10 |
| | i-Type Layer | 180 | $S_iH_4$ : 50<br>$H_2$ : 3000 | 600 | 600 ($220mW/cm^2$) | 2000 |
| | n-Type Layer | 180 | $S_iH_4$ : 10<br>H2 : 2000<br>$PH_3$ : 5 | 200 | 300 ($110mW/cm^2$) | 20 |

Then, a YAG laser was irradiated at a position aside from the patterning position of the transparent conductive film 12 by 50 μm, to pattern the a-Si unit 102 and the μc-Si unit 104 in a strip shape. For the YAG laser, a YAG laser having an energy density of 0.7 J/cm$^3$ and a pulse frequency of 3 kHz was used.

Then, a ZnO film was formed through sputtering as the first backside electrode layer 16 and a Ag electrode was formed through sputtering as the second backside electrode layer 18. Next, YAG laser was irradiated at a position aside from the patterning position of the a-Si unit 102 and the μc-Si unit 104 by 50 μm, to pattern the first backside electrode layer 16 and the second backside electrode layer 18 in a strip shape. As the YAG laser, a YAG laser having an energy density of 0.7 J/cm$^3$ and a pulse frequency of 4 kHz was used.

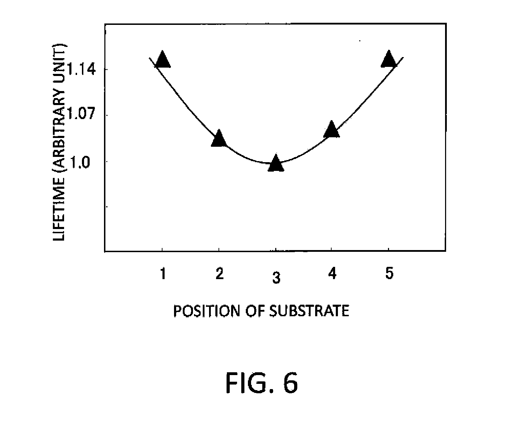

FIG. 6 shows a distribution of the carrier lifetime in the plane of the i-type layer 32 of the μc-Si unit 104 of the tandem-type thin film solar cell 100 formed in the present example. The carrier lifetime was measured by applying the μ-PCD method after a microcrystalline silicon film was formed over a glass substrate to a thickness of 600 nm under the same film formation conditions as the conditions when the i-type layer 32 of the tandem-type thin film solar cell 100 was formed. As shown in FIG. 6, when the lifetime in the first region (position 3) in the center portion in the plane was 1, the lifetime in the second region (positions 1 and 5) at the peripheral portion in the plane was increased to approximately 1.14.

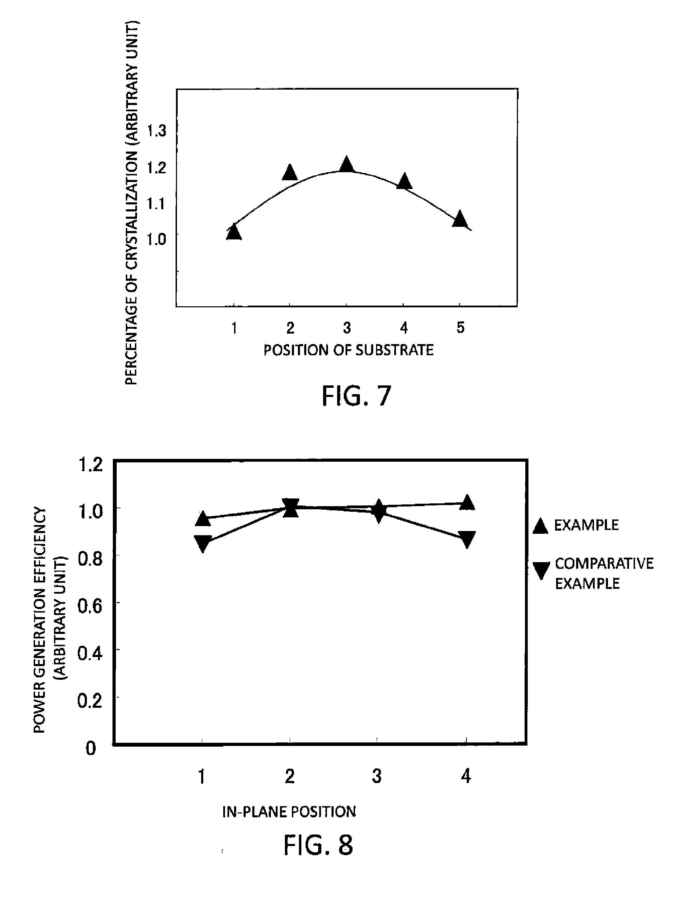

FIG. 7 shows a distribution of the percentage of crystallization in the plane of the i-type layer 32 of the μc-Si unit 104 of the tandem-type thin film solar cell 100 formed in the present embodiment. The percentage of crystallization was measured using Raman spectroscopy after a microcrystalline silicon film was formed over a glass substrate to a thickness of 600 nm under the same film formation conditions as the conditions when the i-type layer 32 of the tandem-type thin film solar cell 100 was formed. As shown in FIG. 7, when the percentage of crystallization in the second region (positions 1 and 5) at the peripheral portion of the plane was 1, the percentage of crystallization in the first region (position 3) at the center portion of the plane was increased to approximately 1.2.

As described, in the present example, by controlling the percentage of crystallization and the carrier lifetime in the plane of the i-type layer 32 of the μc-Si unit 104 in the plane of the tandem-type thin film solar cell 100 in the above-described manner, it was possible to achieve uniform power generation efficiency.

FIG. 8 shows an in-plane distribution of the power generation efficiency of the tandem-type thin film solar cell 100 formed in the present example. FIG. 8 shows normalized power generation efficiencies for the first region (positions 2 and 3) at the center portion of the plane and the second region (positions 1 and 4) at the peripheral portion of the plane. As shown in FIG. 8, the power generation efficiency in the present example had a smaller difference within the plane compared to a comparative example (related art; the carrier lifetime is controlled to be approximately the same in the plane), and more uniform power generation efficiency in the plane was achieved.

This is because in the second region where the percentage of crystallization is lower than the first region, the amount of generation of the carrier at the time of power generation is lower. Because of this, in the configuration where the carrier lifetime is the same in all regions, as in the related art, the amount of generation of current at the second region is reduced compared to the first region, and the power generation efficiency becomes non-uniform over the entire power generation layer. In the present example, on the other hand, because the carrier lifetime is increased in the second region, the amount of generation of current can be increased compared to the first region. As a result, the effective amount of generation of current is balanced between the first region and the second region, and uniform power generation efficiency over the entire power generation layer is achieved.

In addition, the tandem-type thin film solar cell 100 of the present example was made into a panel, placed in an environment of a temperature of 85°C and a humidity of 85% for 1500 hours, and then, a detachment status of the microcrystalline silicon film was checked. As a result, it was found that the tandem-type thin film solar cell 100 in the present example had a reduced tendency to detach at the peripheral portion in the plane compared to the related art. This is because the mixture of moisture can be inhibited, compared to the first region, in the second region where the percentage of crystallization is lower compared to the first region, and by placing the second region at the periphery of the power generation layer it was possible to reduce the mixture of moisture to the inside compared to the case where the overall power generation layer is formed with the first region. Because of this, the degradation of the transparent conductive film 12 can be inhibited and detachment at the peripheral portion in the plane can be inhibited.

REFERENCE NUMERAL LIST

10 TRANSPARENT INSULATING SUBSTRATE; 12 TRANSPARENT CONDUCTIVE FILM; 14 INTERMEDIATE LAYER; 16 FIRST BACKSIDE ELECTRODE LAYER; 18 SECOND BACKSIDE ELECTRODE LAYER; 20 FILLER; 22 BACK SHEET; 30 p-TYPE LAYER; 32 i-TYPE LAYER; 34 n-TYPE LAYER; 100 TANDEM-TYPE THIN FILM SOLAR CELL; 102 a-Si UNIT; 104 μc-Si UNIT

**Claims**

1. A thin film solar cell having a microcrystalline silicon film as a power generation layer, wherein themicrocrystalline silicon film of the power generation layer includes, in its plane, a first region and a second region in which a percentage of crystallization is lower than the first region and a carrier lifetime is higher than the first region.

2. The thin film solar cell according to Claim 1, wherein the second region is a peripheral region of the first region in the plane of the microcrystalline silicon film of the power generation layer.

3. A method of manufacturing a thin film solar cell having a microcrystalline silicon film as a power generation layer, comprising the step of:

   forming the microcrystalline silicon film including, in its plane, a first region and a second region in which a percentage of crystallization is lower than the first region and a carrier lifetime is higher than the first region.

4. The method of manufacturing thin film solar cell according to Claim 3, wherein the microcrystalline silicon film is formed, over a substrate over a surface of which is formed a patterned conductive film, through plasma chemical vapor deposition while maintaining the conductive film corresponding to the first region and the conductive film corresponding to the second region at different potentials.

100

FIG. 1

FIG. 2

FIG. 3

FIG. 4

S2   S1

FIG. 5

FIG. 6

FIG. 7

FIG. 8

<table>
<tr><td colspan="2" align="center">**INTERNATIONAL SEARCH REPORT**</td><td>International application No.<br>PCT/JP2010/052973</td></tr>
</table>

A. CLASSIFICATION OF SUBJECT MATTER
*H01L31/075*(2006.01)i, *H01L31/0368*(2006.01)i, *H01L31/20*(2006.01)i

According to International Patent Classification (IPC) or to both national classification and IPC

B. FIELDS SEARCHED

Minimum documentation searched (classification system followed by classification symbols)
H01L31/00-31/20

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 11-251612 A  (Canon Inc.),<br>17 September 1999 (17.09.1999),<br>& US 2002/0037602 A1 | 1-3 |
| X<br>A | JP 2005-101422 A  (Sanyo Electric Co., Ltd.),<br>14 April 2005 (14.04.2005),<br>(Family: none) | 1,3<br>2,4 |
| X<br>A | JP 9-232235 A  (Mitsui Toatsu Chemicals, Inc.),<br>05 September 1997 (05.09.1997),<br>& EP 729190 A2      & US 5677236 A<br>& DE 69621365 T | 1,3<br>2 |

☒ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>26 March, 2010 (26.03.10) | Date of mailing of the international search report<br>13 April, 2010 (13.04.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/052973

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-294484 A (Canon Inc.),<br>04 November 1998 (04.11.1998),<br>& EP 860885 A2 & CN 1191395 A<br>& US 6043427 A & AU 745050 B<br>& DE 69826161 T | 1-4 |
| P,X | WO 2009/119124 A1 (Mitsubishi Heavy Industries, Ltd.),<br>01 October 2009 (01.10.2009),<br>& JP 2009-246029 A | 1,3<br>2,4 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI11274530 A

**Non-patent literature cited in the description**

- Detection of Heavy Metal Contamination in Semiconductor Processes Using a Carrier Lifetime Measurement System. *KOBE STEEL ENGINEERING REPORTS,* September 2002, vol. 52 (2), 87-93